# DEMANDE DE BREVET EUROPEEN

(11) **EP 1 323 845 A1**
(43) Date de publication de la demande: **02.07.2003**
(21) Numéro de dépôt: 02102893.1
(22) Date de dépôt: 26.12.2002
(51) Int. Cl.: C23C 16/40, H01L 21/316

(54) **Structure multicouche**

(30) Priorité: 31.12.2001 FR 0117069; 11.02.2002 FR 0201618; 27.02.2002 FR 0202461; 20.03.2002 FR 0203442; 20.03.2002 FR 0203445; 20.03.2002 FR 0203444; 17.04.2002 FR 0204782; 25.07.2002 FR 0209458
(71) Demandeur: Memscap, 38190 Bernin (FR)
(72) Inventeur: GIRARDIE, Lionel, 38320, EYBENS (FR)
(74) Mandataire: Palix, Stéphane

(57) **Abrégé**

Structure multicouche, utilisée notamment en tant que matériau de forte permittivité relative, **caractérisée** en ce qu'elle comporte une pluralité de couches distinctes, chacune d'une épaisseur inférieure à 500 Å, et réalisée à base de dioxyde d'hafnium (HfO₂), de dioxyde de Zirconium (ZrO₂) et d'alumine (Al₂O₃). En pratique, les couches de dioxyde d'hafnium, de dioxyde de Zirconium et d'alumine forment des alliages de formule HfₓZrAl_{y}O_{z}. Avantageusement, la stoechiométrie des alliages HfₓZrAl_{y}O_{z} varie d'une couche à l'autre.

## Description

### Domaine technique

L'invention se rattache au domaine de la microélectronique. Elle vise plus précisément une structure multicouche, qui peut être utilisée notamment en tant que matériau de forte permittivité relative. Un tel matériau peut notamment être utilisé pour former la couche isolante d'un condensateur. Un tel condensateur peut notamment être utilisé en tant que capacité de découplage, ou bien encore capacité de filtrage intégrée dans des circuits radiofréquence ou analogues.

Ce type de matériau isolant peut également être utilisé pour être inclus dans des structures capacitives telles que celles formant les cellules de mémoires embarquées (ou embedded DRAM). De telles cellules peuvent être réalisées au sein même d'un circuit intégré.

L'invention permet également de réaliser des couches d'oxyde de grille (ou *gate stack*) que l'on retrouve dans les transistors de structure particulière, également connus sous le nom de structure de grille.

### Techniques antérieures

De façon générale, l'un des objectifs généralement recherché pour réaliser des structures capacitives, qu'il s'agisse de condensateurs ou de cellules de mémoire, est d'augmenter la capacitance de la structure, c'est-à-dire la valeur de la capacité par unité de surface, de manière à réduire au maximum la taille des composants.

Cette recherche d'une plus forte capacitance se fait notamment par l'utilisation de matériaux diélectriques présentant une permittivité relative aussi forte que possible.

La valeur de la capacité est également fonction inverse de la distance séparant les deux électrodes de la structure. C'est pourquoi il est généralement recherché de réduire l'épaisseur de la couche du matériau diélectrique séparant les deux électrodes d'une structure capacitive.

La réduction de cette épaisseur pose toutefois certains problèmes physiques en fonction des matériaux utilisés. En effet, lorsque les couches de matériaux diélectriques sont de très faible épaisseur, on peut voir apparaître certains phénomènes d'effets tunnel qui modifient le comportement de la structure capacitive en en dégradant les propriétés.

Par ailleurs, lorsqu'une couche diélectrique est soumise à une tension de trop forte amplitude, des phénomènes de claquage électrique peuvent également apparaître. On peut donc définir pour chaque matériau un champ électrique maximal de claquage au-delà duquel il ne peut être employé.

Certains matériaux sont par exemple limités à des tensions de l'ordre de quelques volts, alors que le besoin existe de condensateurs utilisés notamment pour les opérations de découplage, susceptibles de supporter la tension supérieure à la dizaine de volts.

En outre, le taux de courant de fuite est également un paramètre qui peut être critique dans certaines applications. On pourra notamment citer les condensateurs fonctionnant à haute fréquence, pour lesquels il est important de conserver un comportement de la capacité sur une bande de fréquence la plus large possible. Le taux de courant de fuite est également critique pour les applications requérant une forte autonomie, lorsque les condensateurs sont notamment embarqués sur des appareils sans fil.

Or, le taux de courant de fuite dépend notamment de la structure cristalline du matériau diélectrique.

On a proposé dans le document FR 2 526 622, de réaliser des structures multicouche associant des couches élémentaires de dioxyde de titane (TiO₂) et d'alumine (Al₂O₃), afin d'obtenir des matériaux présentant une permittivité relative élevée.

Ce type de structure présente l'inconvénient que le dioxyde de titane (TiO₂) est un matériau présentant une faible densité et une permittivité dépendante de la phase cristalline. Cela nécessite donc de le coupler avec un matériau ayant une phase amorphe, y compris jusqu'à une température de 800°C, et présentant un champ de claquage élevé. C'est pourquoi, pour éviter une augmentation de courant de fuite, ce document propose la superposition de couches de TiO₂ et de Al₂O₃. Les performances électriques de ce matériau sont utilisées pour des application de TFT (transistor thin film) mais sont insuffisantes pour des applications de découplage par des cellules de capacités. En effet, pour certaines applications, les courants de fuite sont déterminants pour un fonctionnement en radio-fréquence (RF), et notamment pour les générations de dispositifs de technologie CMOS et BICMOS HBT utilisés dans les appareils de communications sans fils, et notamment les futurs générations de téléphones mobiles connus sous l'appellation d'UMTS. Pour cette dernière application, la norme sur le découplage est telle qu'elle exige d'atteindre des courants de fuite inférieurs à 10⁻⁹ A/cm², à des tensions d'alimentation de 5,5V, en ayant un champ de claquage supérieur à 6 MV/cm. Pour qu'un matériau diélectrique puisse être utilisé dans cette application, il doit posséder une énergie d'inter bande (ou band gap) supérieur à 5.5 eV. Or l'empilement de couches de TiO₂ et Al₂O₃ ne possède qu'une énergie d'inter bande de 4 eV , un champ de claquage voisin de 3,5 MV/cm et des courants de fuite proche de 10⁻⁶ A/cm². Il apparaît très nettement que le matériau décrit dans ce document, développé pour des applications de TFT, ne peut être réutilisé pour des applications de condensateur de découplage RF et de cellule de capacité intégrée dans les circuits intégrés de technologie CMOS et BICMOS HBT

L'un des objectifs de l'invention est de proposer un matériau qui puisse être utilisé au sein de structures capacitives diverses, qui combine à la fois une forte valeur de permittivité relative avec une bonne tenue à la tension et un faible niveau de courant de fuite.

### Exposé de l'invention

L'invention concerne donc une structure multicouche, qui peut être réalisée notamment en tant que matériau de forte permittivité relative.

Conformément à l'invention, cette structure se caractérise en ce qu'elle comporte une pluralité de couches distinctes, chacune d'une épaisseur inférieure à 500 Angströms (Å). Certaines de ces couches sont réalisées à base de dioxyde d'hafnium (HfO₂), de dioxyde de Zirconium (ZrO₂), et d'alumine (Al₂O₃). Avantageusement en pratique, les couches de dioxyde d'hafnium et d'alumine forment des alliages de formule HfₓZrₜAl_{y}O_{z}. Avantageusement, la stoechiométrie des alliages HfₓZrₜAl_{y}O_{z} varie d'une couche à l'autre.

Autrement dit, le matériau obtenu conformément à l'invention se présente sous forme d'une alternance de films ayant des compositions et des stoechiométries différentes, pour des épaisseurs inférieures à quelques centaines d'Angströms, formant ainsi une structure nanolaminée. En pratique, l'épaisseur des couches peut être préférentiellement inférieure à 200 Å, ou bien encore à 100 Å, voire même à 50 Å. En pratique, la structure peut comporter au moins cinq couches.

On a constaté de façon surprenante que les alliages de dioxyde d'Hafnium, de dioxyde de zirconium et d'alumine présentaient des propriétés qui s'apparentent aux propriétés les plus favorables de chacun des composants de l'alliage.

Ainsi, le dioxyde d'Hafnium est connu pour être un matériau de structure polycristalline. Cette structure cristalline conduit le dioxyde d'Hafnium à être le siège de courants de fuite relativement élevés, bien que ce matériau soit très peu sensible aux phénomènes d'avalanches

Les courants de fuite du dioxyde d'Hafnium sont toutefois limités en raison de sa composition atomique et de sa faible densité en lacune d'oxygène. Le dioxyde d'Hafnium est également résistant à la diffusion d'impuretés et à l'intermixage aux interfaces, en raison notamment de sa forte densité, à savoir de 9,68 g/cm². Le mécanisme de ces courants de fuite est basé sur des effets tunnel.

Le dioxyde d'Hafnium est également connu pour sa permittivité relative plutôt élevée, et de l'ordre de 20, lorsque ce matériau est déposé par ALD (de l'anglais Atomic Layer Deposition) à une température inférieure à 350°C.

S'agissant de la tenue en tension, le dioxyde d'Hafnium possède une énergie d'interbande ou band gap de 5,68 eV, pour un champ de claquage de 4 MV/cm.

En ce qui concerne l'uniformité de la permittivité relative, le diagramme courant-tension montre une hystérésis. Conformément à l'invention, cette hystérésis est très nettement atténuée grâce à la superposition de couches d'alliages d'oxydes d'alcalino-terreux, dont la mixité des atomes contribue à un désordre et une intégrité du matériau plus élevée. Par ailleurs, l'hystérésis est réduite par l'emploi de précurseurs dont les ligands de chaque molécule libérée désorbent moins d'impureté de type Carbone, Chlore, Hydrogène et Azote. En effet, de telles impuretés sont généralement à la base des radicaux et provoquent des modifications comportementales en fonction des états de polarisation. Cela signifie que pour une légère variation de tension appliquée au matériau, celui-ci ne présente pas exactement les mêmes propriétés de permittivité, ce qui peut introduire des défauts de comportement électrique de la capacité, notamment lorsqu'elle est soumise à des sauts de tension.

Le matériau diélectrique faisant l'objet de la présente invention présente, pour une épaisseur inférieure à 50 Å, une épaisseur équivalente en SiO₂ ( ou "EOT" pour Equivalent Oxide Thickness ) de 9,9 Angströms. Cette valeur est particulièrement proche de l'épaisseur de 10 Angströms caractéristique de l'oxyde de grille d'un transistor à effet de champ d'une largeur de grille de 70 nanomètres. En d'autres termes, le matériau diélectrique de l'invention est particulièrement bien adapté pour réaliser les oxydes de grilles de tels transistors. Cette valeur de EOT résulte du mixage des couches atomiques d'oxydes alcalino-terreux basé sur l'Hafnium, le Zirconium et l'Aluminium et par les molécules aux ligands particuliers dont les réactions de thermolyse et de chimie-sorption se font dans une gamme de température de 250°C à 325°C, et préférentiellement entre 280°C et 290°C. Cet écart étroit empêche les migrations d'impuretés et de formation de phases en raison du comportement entropique des dépôts par la technique ALD.

Par ailleurs, le dioxyde de zirconium est également connu pour être un matériau de structure polycristalline. Le dioxyde de zirconium est le siège de courants de fuite relativement élevés, encore supérieurs à ceux du dioxyde d'Hafnium, du fait que le dioxyde de zirconium présente un nombre relativement élevé de lacunes en oxygène.

En ce qui concerne la tenue en tension, le dioxyde de zirconium possède une énergie d'interbande ou band gap relativement élevée, à savoir de 7,8 eV, et présente un champ de claquage relativement faible, de l'ordre de 2,2 MV/cm. La permittivité relative du dioxyde de zirconium est relativement élevée, de l'ordre de 22.

En ce qui concerne l'autre composant de l'alliage, à savoir l'alumine, celui-ci est connu pour posséder une structure cristalline amorphe, favorable aux faibles courants de fuite, qui suivent le mécanisme de Poole-Frenkel. L'alumine présente une permittivité relative de 8,4, valeur inférieure à celle des dioxydes d'Hafnium et de Zirconium.

En revanche, l'alumine présente une énergie d'interbande de 8,7 eV, et un champ de claquage de 7 MV/cm, valeurs supérieures à celles des dioxydes d'Hafnium et de Zirconium évoquées ci-avant.

Or, on a remarqué de façon surprenante, que les alliages HfₓZrₜAl_{y}O_{z} formés par ces trois matériaux, présentent des propriétés particulièrement intéressantes, notamment en ce qui concerne la permittivité relative, qui est de l'ordre de 14 à 20 à la température de déposition, et qui peut atteindre entre 21 et 33 en fonction des étapes ultérieures de recuit, à des températures variant entre 450°C et 850°C . La tenue en tension est également avantageuse, puisque le champ de claquage global est de l'ordre de 8,9 MV/cm.

Par ailleurs, les alliages formés à base de HfO₂, ZrO₂ et Al₂O₃ permettent de stopper la croissance des grains de dioxyde d'Hafnium et de Zirconium par les phases amorphes d'alumine. On obtient donc un résultat qui se caractérise par la réduction des courants de fuite, alors qu'a priori, les deux matériaux pris séparément n'ont pas de mécanisme commun en ce qui concerne les courants de fuite.

Les alliages HfₓZrₜAl_{y}O_{z} formés et déposés par ALD présentent des avantages par rapport à une structure nanolaminée qui serait composée de l'empilement de couches successives de HfO₂, ZrO₂, et de Al₂O₃. Ces avantages sont intimement liés à la structure des grains de l'alliage, à sa densité, et à l'enthalpie de formation qui donnent des courants de fuite de l'ordre de 10⁻⁷ A/cm² à 6 V, pour une épaisseur de l'ordre de la centaine d'Angströms. En outre la permittivité relative est supérieure et l'énergie de transition d'électron (ou barrière) par rapport à un métal est supérieure à 3,4 eV. L'inter bande de l'alliage HfₓZrₜAl_{y}O_{z} est supérieure à 7,6 eV, alors que la structure nano-laminée composée de couches distinctes de HfO₂, ZrO₂ et de Al₂O₃ présente une énergie d'inter bande de 5,7 eV .

Par ailleurs, la forte cohésion des cristaux, et la faible densité de lacune d'oxygène conduisent à une bonne uniformité de la permittivité relative de l'alliage caractéristique, lorsque ceux-ci sont déposés par la technique "ALD", pour "Atomic Layer Deposition" ou "dépôt de couches atomiques". Les courants de fuite observés sont typiquement de l'ordre du nanoampère par cm² sous une tension de 6 volts, et pour une épaisseur de films inférieure à 10 nanomètres.

Dans une forme de réalisation particulière, la structure multicouche de l'invention peut comporter des couches externes qui sont réalisées uniquement en alumine. En effet, dans ce cas, on a observé que l'alumine Al₂O₃ présente une haute valeur de champ de claquage, et une énergie interbande relativement élevée, en comparaison aux principaux métaux, et notamment au tungstène qui est couramment utilisé pour former des électrodes de structures capacitives. Le seuil de tension de transition entre l'alumine et le tungstène est de l'ordre de 3,4 volts, ce qui rend l'alumine particulièrement avantageuse dans l'interface avec des électrodes métalliques et notamment en tungstène.

### Exemples de réalisation

Les différentes structures nanolaminées décrites ci-après ont été réalisées en utilisant des techniques de dépôt ALD, en déposant les différents composants de l'alliage à une température comprise entre 320 et 350°C de manière simultanée

Grâce à cette technique, il est possible de maîtriser l'épaisseur de chacune des couches, et ainsi de garantir une bonne homogénéité de cette épaisseur sur toute la surface de la couche élémentaire, et donc d'éviter les sources de défectivité.

La technique de dépôt par ALD peut utiliser plusieurs sources de matériaux, à savoir des sources solides, liquides ou gazeuses, ce qui rend cette technique très souple et évolutive. Par ailleurs, elle utilise des précurseurs qui sont les vecteurs de la réaction chimique de surface et qui transportent la matière à déposer. Plus précisément, ce transport met en oeuvre un processus de chimie sorption des précurseurs sur la surface à recouvrir, en créant une réaction chimique avec échange de ligand entre les atomes en surface et les molécules des précurseurs.

Le principe de cette technique évite l'adsorption des précurseurs ou leur condensation, et donc leur décomposition. Des sites nucléiques sont continuellement créés jusqu'à la saturation de chaque phase de la réaction, entre lesquels une purge à l'aide de gaz inerte permet de renouveler le processus. L'uniformité du dépôt est assurée par le mécanisme de réaction et non pas par les réactants utilisés, comme c'est le cas dans les techniques de Chemical Vapor Deposition (CVD), puisque l'épaisseur des couches déposées par ALD dépend de chaque cycle de chimie sorption des précurseurs.

Pour cette technique, il sera préférentiellement utilisé comme précurseurs des chlorites et oxychlorures telles que HfCl₄, ZrCl₄ sous atmosphère de tri-méthyl ammonium (TMA) et Ozone ou H₂O, des métallocènes, des acyles de métaux tels que Al(CH₃)₃, des béta dikétonates, ou des alkoxides .

Parmi les différents exemples réalisés, on notera :

### Exemple A

| ***N° de la couche*** | ***Formule de la couche*** | ***Epaisseur de la couche*** |
|---|---|---|
| 1 | Hf ZrAl₆O₁₃ | 10 angstroms |
| 2 | Hf₂ ZrAl₂O₉ | 20 angstroms |
| 3 | Hf ZrAl₄O₁₀ | 12 angstroms |
| 4 | Hf Zr₂AlO_{7,5} | 25 angstroms |
| 5 | Hf ZrAl₃O_{8,5} | 12 angstroms |
| 6 | Hf₂ ZrAlO_{7,5} | 25 angstroms |
| 7 | Hf ZrAl₂O₇ | 12 angstroms |
| 8 | Hf Zr₂Al₂O₉ | 20 angstroms |
| 9 | Hf₂ ZrAlO_{7,5} | 15 angstroms |
| 10 | Hf ZrAl₆O₁₃ | 10 angstroms |

Cette structure nanolaminée présente une permittivité relative de l'ordre de 19 et présente un champ de claquage de 8,5 MV/cm, une énergie d'inter bande de 7,8 eV et une énergie de transition électronique par rapport au nitrure de tungstène (WN) de 3,9 eV.

### Exemple B

| ***N° de la couche*** | ***Formule de la couche*** | ***Epaisseur de la couche*** |
|---|---|---|
| 1 | Al₂O₃ | 10 angstroms |
| 2 | Hf₂ ZrAl₂ O₉ | 15 angstroms |
| 3 | HfZrAl₄ O₁₀ | 12 angstroms |
| 4 | Hf₂ ZrAlO_{7,5} | 25 angstroms |
| 5 | HfZrAl₃ O_{8,5} | 12 angstroms |
| 6 | HfZr₂AlO_{7,5} | 25 angstroms |
| 7 | HfZrAl₂ O₇ | 12 angstroms |
| 8 | HfZrAlO_{7,5} | 20 angstroms |
| 9 | HfZr₂Al₂ O₉ | 15 angstroms |
| 10 | Al₂O₃ | 10 angstroms |

Cette structure nanolaminée présente une permittivité relative de l'ordre de 16, et présente un champ de claquage de 8,5 MV/cm.

Bien entendu, les valeurs stoechiométriques données à ces différents exemples ne limitent pas la portée de l'invention, mais cette dernière couvre également de nombreuses autres variantes dès lors qu'elles respectent le principe de l'invention, à savoir une variation de la stoechiométrie entre les différents composants de l'alliage d'une couche à l'autre.

## Revendications

1. Structure multicouche, utilisée notamment en tant que matériau de forte permittivité relative, **caractérisée en ce qu'**elle comporte une pluralité de couches distinctes, chacune d'une épaisseur inférieure à 500 Å, et dont au moins une est réalisée à base de dioxyde d'hafnium (HfO₂), de dioxyde de Zirconium (ZrO₂) et d'alumine (Al₂O₃).

2. Structure multicouche selon la revendication 1, **caractérisée en ce que** les couches à base de dioxyde d'hafnium (HfO₂), de dioxyde de Zirconium (ZrO₂) et d'alumine (Al₂O₃) sont formées d'alliages de formule HfₓZrₜAl_{y}O_{z}.

3. Structure multicouche selon la revendication 2, **caractérisée en ce que** les stoechiométries des alliages de formule HfₓZrₜAl_{y}O_{z} varient d'une couche à l'autre.

4. Structure multicouche selon la revendication 1, **caractérisée en ce que** l'épaisseur de chaque couche est comprise entre 1 et 200 Å, préférentiellement entre 1 et 100 Å, très préférentiellement entre 1 et 50 Å.

5. Structure multicouche selon la revendication 1, **caractérisée en ce qu'**elle comporte au moins cinq couches.

6. Structure multicouche selon la revendication 1, **caractérisée en ce que** au moins une des couches externes est réalisée en alumine (Al₂O₃)

7. Structure multicouche selon la revendication 1, **caractérisée en ce que** chaque couche est déposée par la technique de "dépôt de couches atomiques" (ALD).
